(19) Europäisches Patentamt
European Patent Office
Office européen des brevets

(11) **EP 1 704 428 B1**

(12) **EUROPEAN PATENT SPECIFICATION**

(45) Date of publication and mention
of the grant of the patent:
**28.05.2008 Bulletin 2008/22**

(21) Application number: **03789424.3**

(22) Date of filing: **24.12.2003**

(51) Int Cl.:
*G02B 5/20* (2006.01)    *H01S 5/00* (2006.01)

(86) International application number:
**PCT/EP2003/014917**

(87) International publication number:
**WO 2005/064365 (14.07.2005 Gazette 2005/28)**

(54) **TUNABLE RESONANT GRATING FILTERS**

ABSTIMMBARER RESONANTER GITTERFILTER

FILTRES ACCORDABLES A RESEAU DE DIFFRACTION RESONANT

(84) Designated Contracting States:
**AT BE BG CH CY CZ DE DK EE ES FI FR GB GR HU IE IT LI LU MC NL PT RO SE SI SK TR**

(43) Date of publication of application:
**27.09.2006 Bulletin 2006/39**

(60) Divisional application:
**08154863.8**

(73) Proprietor: **Pirelli & C. S.p.A.**
**20123 Milano (IT)**

(72) Inventors:
• **PIETRA, Giulia**
**I-27028 San Martino Siccomario (Pavia) (IT)**
• **GORNI, Giacomo Maria**
**I-20126 Milano (IT)**

(74) Representative: **Montevecchi, Emma et al**
**Cantaluppi & Partners S.r.l.,**
**Via Matteotti, 26**
**35137 Padova (IT)**

(56) References cited:
**WO-A-02/084824        US-A- 5 193 130**
**US-A- 5 337 183        US-B1- 6 215 928**

• **DUDOVICH N ET AL: "ACTIVE SEMICONDUCTOR-BASED GRATING WAVEGUIDE STRUCTURES" IEEE JOURNAL OF QUANTUM ELECTRONICS, IEEE INC. NEW YORK, US, vol. 37, no. 8, August 2001 (2001-08), pages 1030-1039, XP001111724 ISSN: 0018-9197**
• **PATENT ABSTRACTS OF JAPAN vol. 0130, no. 50 (P-823), 6 February 1989 (1989-02-06) & JP 63 244004 A (SEIKO EPSON CORP), 11 October 1988 (1988-10-11) cited in the application**

EP 1 704 428 B1

## Description

The invention concerns a tunable resonant grating filter, especially adapted for wavelength-division multiplexed optical communication networks. In particular the invention relates to a tunable resonant grating filter used as tunable mirror in an external-cavity tunable laser for wavelength-division multiplexing.

## Related art

Guided-mode resonance effect in planar waveguide gratings can be utilized to produce ideal or nearly-ideal reflection filters. For an incident wavelength (or frequency) equal to the respective resonant wavelength of the filter, the incident radiation is dominated by resonant reflection and transmission through the device is precluded. For all other values of incident wavelength, the device is substantially transparent.

Properties of resonant grating filters have been studied. In "Multilayer waveguide-grating filters" by Wang S.S. and R. Magnusson, published in Applied Optics, vol. 34 (1995), p. 2414, resonance reflection filters constructed with multiple thin-film layers are addressed. In "Design considerations for narrow-band dielectric resonant grating reflection filters of finite length" by Donald K.J. et al., J. Opt. Soc. Am. A (2000), p. 1241, a multiple-scattering interference-waveguide approach is developed to predict the response of a resonant grating reflection filter.

Generally, the structure of a resonant grating filter comprises a diffraction grating with high-index and low-index regions, which is located on a waveguide layer, typically placed on a substrate that supports the layer(s). The waveguide layer, or core layer, serves as a cavity in which discrete modes can propagate: The grating on top of the waveguide couples an incident illumination plane wave to the discrete modes within the waveguide:

As explained in "Resonant Grating Waveguide Structures" by Rosenblatt D. et al., published in IEEE Journal of Quantum Electronics, vol. 33 (1997), p. 2038, when a resonant grating waveguide structure is illuminated with an incident light beam, part of the beam is directly transmitted and part is diffracted and subsequently trapped in the waveguide layer. Some of the trapped light in the waveguide layer is then rediffracted out so that it interferes with the transmitted part of the light beam. At a specific wavelength and angular orientation of the light beam, the structure "resonates", i.e., complete destructive interference between the directly transmitted field and diffracted contributions occurs and no light is transmitted. The bandwidth of the resonance is based on parameters such as depth, duty cycle (the ratio of step width to grating period) and refractive index contrast of the grating, as well as thickness of the waveguide layer. The bandwidth can be designed to be very narrow (on the order of 0.1 nm).

In "Very narrow spectral filters with multilayered grating-waveguide structures" by G. Levy-Yurista and A.A. Friesem, published in Applied Physics Letters, vol. 77 (2000), p. 1596, a resonant grating-waveguide structure is described, in which the grating layer is separated from the waveguide layer by a buffer layer which serves also as a stop layer of the etching process. It is said that by separating the waveguide and the grating layers, it is possible to optimize and control their thickness to a higher degree.

The resonance wavelength of a resonant grating filter can be controlled by varying the refractive index of the different layers in the structure. Such a variation of the refractive index leads to a different phase matching condition, and accordingly to a resonance wavelength shift. For example, refractive index variations can be induced by applying an external electric field. In "Active Semiconductor-Based Grating Waveguide Structures" by Dudovich N. et al., published in IEEE Journal of Quantum Electronics, vol. 37 (2001), p. 1030, active grating waveguide structures with InGaAsP/InP materials and based on a reverse-voltage configuration are described.

Tunable optical filters have many applications in optical telecommunications, in particular in wavelength division multiplexing (WDM). In WDM systems, several channels with a different wavelength are transmitted over an optical fiber, each channel carrying different information. A tunable filter can be used to select and filter out one arbitrary channel. In order to accommodate increasing optical communication traffic, dense WDM (DWDM) systems with channel spacing of 50 GHz and eventually of 25 GHz are under development. DWDM systems with 50 GHz channel spacing typically require frequency accuracy of $\pm 2.5$ GHz, whereas systems with 25 GHz generally require an accuracy of $\pm 1.25$ GHz. As DWDM uses narrower channel spacing, the passing band of the filters should also narrow in order to avoid cross-talk between different channels.

Resonant grating filters are particularly suitable as tunable filters for applications in WDM systems, owing to the relatively high intrinsic wavelength selectivity that is created from the resonance condition, thereby making narrow FWHM in principle possible (ideally down to 0.1 nm, or even lower).

"*A tunable Subwavelength Resonant Grating Optical Filter*" by Hua Tan et al., published in the proceedings of LEOS 2002, p.825, describes resonant grating filter in which tuning of the resonant wavelength is obtained by tuning a liquid crystal (LC) layer, which is placed as a cladding layer for the filter. A tuning range of 17 nm was achieved, while simulations showed that the LC filter had the potential of achieving 55 nm tuning range and 0.1 nm bandwidth.

The use of lasers as tunable light source can greatly improve the reconfigurability of WDM and DWDM systems. For example, different channels can be assigned to a node by simply tuning the wavelength.

Different approaches can be used to provide tunable lasers, distributed Bragg reflector lasers, VCSEL lasers with a mobile top mirror, or external-cavity diode lasers. External-cavity tunable lasers offer several advantages, such as high output power, wide tuning range, good side mode suppression and narrow bandwidth. Various laser tuning mechanisms have been developed to provide external-cavity wavelength selection, such as mechanically adjustable or electrically activated intracavity selector elements.

Wavelength selection and tuning of a laser cavity can be performed by using an active tunable mirror. US patent No. 6,215,928 describes an active tunable mirror including a diffraction grating formed on a planar waveguide and a cladding layer which at least fills the interstices of the diffraction grating. The cladding can be formed of a liquid crystal material that can be electro-optically tuned. The resonant wavelength may be shifted by varying the voltage or current supplied to the electro-optically controlled element.

U.S. patent No. 6,205,159 discloses an external-cavity semiconductor laser that tunes to a discrete set of wavelengths by changing the voltage to a liquid crystal Fabry-Perot (LC-FP) interferometer. The discrete set of wavelengths one may tune to is defined by a static intracavity etalon. The static intracavity etalon's free spectral range (FSR) is designed so that it is greater than the resolution bandwidth of the LC-FP interferometer. The FWHM linewidth of the static etalon must be less than the external cavity longitudinal mode spacing.

Applicants have noted that structural parameters, such as thickness of the waveguide or grating layers or grating period, of the resonant grating filters are crucial in order to obtain a filter having a relatively high tuning range, for instance not smaller than 30-40 nm, and a relatively narrow bandwidth at FWHM, preferably not larger than 100 GHz (0.8 nm), as required for instance as tunable element in tunable lasers for WDM systems operating in the erbium C-band with 100 GHz spaced channels.

JP patent application No. 63-244004 describes a waveguide grating element which can be used to produce a deflection element or a focus lens. In the described device, light is incident laterally along the waveguide. Changes in the refractive index of the LC material induce variations in the light deflection angle making it possible to control the angle of the output light by means of an externally applied voltage.

Similarly, US patent No. 5,193,130 discloses a light deflecting device in which a voltage signal changes the aligning direction of a LC layer near the surface of a waveguide layer. In the described device, waveguide light propagating along the waveguide is separated into two light beams: the first radiated to the LC and the second radiated towards the substrate due to the presence of a grating. The direction of the radiated light outside of the waveguide layer is changed by applying a voltage signal.

In US patent No. 5337183. an optical apparatus consisting of a laser for producing a coherent polarized beam of electromagnetic radiation of a preselected wavelength is disclosed. A substrate of silicon has a first transparent cover layer for receiving the polarized beam substantially normally incident thereto, and a second transparent guide layer for receiving the polarized beam from the first layer and for supporting at least one resonant mode. The first and second layers have a preselected index of refraction and a grating is interposed therebetween them, having a grating period less than half the preselected wavelength. The layers and grating interact to produce a standing wave resonance by Bragg reflection. A control obtains a resonance wavelength in the guide layer equal to the predetermined radiation wavelength and thereby high reflectance to modulate the polarized beam. The grating can be optimized for angular bandwidth by controlling the grating's Fourier components either in a single layer or in two grating layers which can also include a terminator

## Summary of the invention

The invention relates to a tunable resonant grating filter as defined in claim 9. It can reflect optical radiation at a resonant wavelength, said resonant wavelength being selectively variable. The filter comprises a periodic structure having low-(refractive) index and high-index regions, i.e., a diffraction grating, a planar waveguide and a light transmissive material having a selectively variable refractive index to permit tuning of the filter, said light transmissive material forming a tunable cladding layer for the waveguide. The light transmissive material is preferably an electro-optical light-transmissive material, more preferably a liquid crystal (LC) material.

Optical properties of resonant grating filters are governed by their structural characteristics, such as thickness of the grating layer, thickness of the waveguide layer or index contrast between the low-index and the high-index regions of the grating. Applicants have observed that an appropriate choice of structural characteristics of the device results in a useful trade-off between narrow bandwidth and wide-range tunability.

Applicants have found that by placing the diffraction grating on the opposite side of the tunable layer with respect to the planar waveguide it is possible to tailor the grating structural parameters to the desired bandwidth of the filter response without significantly affecting the tunability of the filter. In other words, a resonant structure including a diffraction grating under the waveguide allows flexibility in the selection of a suitable grating structure having a relatively small coupling efficiency, as required for bandwidth resolution, while attaining the desired tuning range. Within this resonant structure, the core layer, i.e., the waveguide, can be placed close to the tunable layer, either in direct contact with the tunable layer or with an interposed relatively thin intermediate layer(s) between the core and the tunable layer. Proximity of the core layer to the tunable layer implies that the propagation mode can significantly extend into the tunable layer so that the effective refractive index of the fundamental mode in the waveguide is efficiently affected by variations of the refractive index of the tunable layer.

Applicants have realized that a grating with a relatively low coupling efficiency is desirable in order to obtain a resonant filter exhibiting a relatively narrow bandwidth. Preferably, in order to obtain a bandwidth at FWHM not larger than about 0.6 nm (suitable in particular for tunable lasers DWDM systems with 50 GHz channel spacing) the coupling coefficient should be not larger than about 0.0026. More preferably, the coupling efficiency should be comprised between about 0.001 and 0.002.

By manufacturing a resonant grating structure in which the core layer is interposed between the grating and the tunable layer fabrication tolerances of some of the structural parameters can be relaxed as tuning range is demonstrated to be less affected by variations in the grating parameters. In addition, there is no need of fabricating a grating with small thickness, i.e., smaller than 150-200 nm, in order to obtain a weak grating, i.e., with coupling coefficient not larger than 0.0026.

The tunable resonant grating filter of the present invention is particularly suitable for applications in external-cavity tunable lasers for DWDM systems with 50 GHz and 25 GHz channel spacing design. The tunable resonant grating filter of the present invention can be made tunable over the entire erbium C-band (1530-1570 nm).

In one of its aspects, the invention relates to an external-cavity tunable laser comprising a tunable resonant grating filter.

**Brief description of the drawings**

Fig. 1 is a simplified illustration of the layer structure of a resonant grating filter and the relevant incident and diffracted waves for normally incident radiation.

Figs. 2(a) to 2(c) show the calculated bandwidth at FWHM of a resonant grating filter as a function of the diffraction grating thickness for different values of the thickness of the core layer. In (a) the refractive index contrast, $\Delta n_G / n_G$, is 0.26, in (b) 0.07 and in (c) 0.04.

Fig. 3 is a simplified illustration of the layer structure of a resonant grating filter comprising a "gap" layer between the core and the grating layers.

Fig. 4 displays the calculated bandwidth at FWHM of a resonant grating filter of the type shown in Fig. 3 as a function of the diffraction grating thickness for different values of the thickness of the gap layer ranging from 0 nm (no gap layer) to 300 nm (the value of the thickness of the core layer is the same for all curves).

Figs. 5(a) and 5(b) show the normalized optical mode distribution (solid line) with respect to the different layers of the structure of a resonant grating filter of the type of Fig.1 for two different values of the refractive index $n_1$ of the tunable layers, $n_1=1.5$ (a) and $n_1=1.7$ (b).

Fig. 6 is a simplified illustration of the layer structure of a resonant grating filter comprising an "intermediate" layer between the core and the tunable layers.

Fig. 7 displays the calculated tuning range as a function of the core layer thickness for different values of the thickness of the intermediate layer ranging from 0 nm (i.e. no intermediate layer) to 200 nm.

Fig. 8 is a simplified illustration of the layer structure of a resonant grating filter according to an embodiment of the present invention.

Figs. 9(a) and 9(b) reports a comparison between the optical properties of a structure of the type of Fig. 1 and those of a structure of the type shows in Fig. 8, the latter structure having no intermediate layer. In (a) the bandwidth at FWHM is shown as a function of grating thickness, whereas in (b) the tuning range is reported, always as a function of the grating thickness.

Fig. 10 is a simplified illustration of the layer structure of a resonant grating filter according to a further embodiment of the present invention.

Fig. 11 displays the calculated bandwidth at FWHM as a function of the coupling efficiency, exemplary of the FWHM dependence on the "strength" of the diffraction grating.

Figs. 12(a) and 12(b) show the calculated bandwidth at FWHM (a) and the tuning range (b) of a resonant grating filter of the type shown in Fig. 10 as a function of the diffraction grating thickness for different values of the thickness of the gap layer.

Fig. 13 reports for comparison the calculated tuning range as a function of the grating thickness of a resonant grating filter of the type shown in Fig. 3 for different values of the thickness of the gap layer, ranging from 0 nm (i.e. non gap layer) to 300 nm.

Fig. 14 is a schematic view of an external-cavity tunable laser including a grating resonant filter according to an embodiment of the present invention.

**Detailed description**

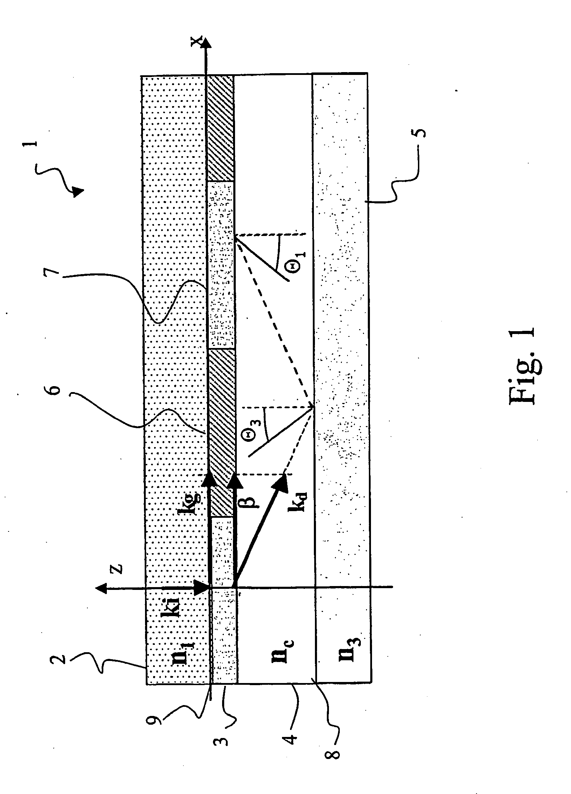

Applicants have studied a structure of the resonant grating filter (also referred to as the resonant structure) of the type schematically depicted in Fig.1. Resonant structure 1 comprises a waveguide, i.e., core layer 4, formed on a underlying cladding layer 5 and a diffraction grating layer 3 including low-index regions 6 and high-index regions 7 having refractive index $n_L$ and $n_H$, respectively. The refractive index contrast between the low- and the high-index regions of the grating, $\Delta n_G/n_G$, is defined as

$$\frac{\Delta n_G}{n_G} = \frac{n_H - n_L}{[Fn_L + (1-F)n_H]} \quad (1)$$

where $n_G$ is the average value of the refractive index of the grating and F the duty cycle of the grating.

A cladding layer 2 is formed on grating 3, the cladding layer being formed of a tunable material, preferably of a LC material having a relatively wide range of selectable refractive indices. The refractive index of the core layer 4, $n_c$, is larger than the surrounding layers to guarantee confinement of the optical modes along the waveguide. Layer 5 could be optionally grown on a substrate (not shown) or be itself (function as) a substrate. For example, the core layer 4 can be made of $Si_3N_4$, layer 5 can be made of (undoped) $SiO_2$, preferably grown on a Si substrate (not shown). Alternatively, layer 5 can be a glass substrate on which the core layer is grown.

By defining a Cartesian coordinate system (x,y,z) with reference to the main directions of the filter, the z-axis being normal to the main surface of the waveguide, when a light beam impinges on structure 1, light is diffracted by grating 3. In the example shown in Fig.1, incidence is normal to the structure, i.e., along the z direction. The grating is preferably designed with a period $\Lambda$ such that only the zero order and the first diffracted order are allowed to propagate in the waveguide; all other diffracted orders are evanescent. The zero order will propagate along the z direction across the multilayer structure, while the first diffracted order will propagate inside the core region with a diffraction angle which is dependent mainly on the grating period and on the core refractive index. If the diffracted angle exceeds the critical angles defined by the interfaces 8 and 9 between the core layer 4 and the surrounding layers (within the present approach the grating is treated as a small perturbation and therefore considered to be an interface), the diffracted order will propagate in the waveguide along the x-axis. The critical angle of an interface between two layers of different refractive index is defined as the minimum angle at which total reflection occurs, namely by referring to Fig. 1, $\sin\Theta_{1,3}=n_{1,3}/n_c$.

Under resonance condition, the incident light is coupled to the fundamental mode propagating in the core layer along the x-axis. The light propagating along the x-axis with a defined propagation constant $\vec{\beta}$ is diffracted by the periodic perturbation (the grating) and exits again the waveguide. The periodic perturbation couples the light back into the z direction with a resulting reflection along the z-axis at the resonance wavelength. All other wavelengths are substantially transmitted through the device. At resonance, standing waves are produced in the waveguide layer that behaves like a resonant cavity in which light is confined by total internal reflections with a consequent energy build-up.

For resonance to occur, the value of $\vec{\beta}$ of the fundamental mode in the tangential direction, i.e., along the x-axis, at the grating-core interface is given by

$$\overline{k_i^x} + \overline{k}_g = \overline{\beta} \quad (2)$$

where $k_i^x$ is the component along the x direction of the wave number of the incident beam and $k_g$ is the wave number of the grating, defined as

$$\overline{k}_g = \frac{2\pi}{\Lambda}\hat{x} \quad (3)$$

where $\Lambda$ is the grating period. As in the present case we consider normal incidence, $k_i^x=0$. Therefore, the relation between the propagation constant of the fundamental mode and the grating period is given by

$$\overline{\beta} = \frac{2\pi}{\Lambda}\hat{x} \qquad (4)$$

Although in Fig. 1 a normal incidence of the light beam is illustrated and discussed, the condition of normal incidence is not a necessary requirement. When incidence at an angle $\vartheta$ is considered, the resonance condition should take into account also the angular orientation of the beam as it occurs at a specific resonance wavelength $\lambda_0$ and angle $\vartheta_0$.

It is known that the resonance wavelength $\lambda_0$ is a non trivial solution of the eigenvalue problem given by

$$tg(u \cdot t_c) = \frac{u(w_2 + w_5)}{u^2 - w_2 w_5} \qquad (5)$$

where $t_c$ is the waveguide (core) thickness, u is the modal parameter of the propagating waves in the core, and $w_2$ and $w_5$ are the modal parameters of the cladding layers 2 and 5 (Fig.1). The modal parameters can be expressed by the following equations

$$u = \sqrt{\left(\frac{2\pi}{\lambda}n_c\right)^2 - \beta^2} \qquad (6)$$

$$w_{2,5} = \sqrt{\beta^2 - \left(\frac{2\pi}{\lambda}n_{1,3}\right)^2} \qquad (7)$$

where $\lambda$ is the wavelength of the incident light.

Following a multipath interference approach of the transversal resonance, it is possible to derive an analytical expression of the bandwidth of the spectral response of the structure at resonance as a function of the grating and waveguide parameters. The reflection efficiency of the first diffracted order in the core layer can be expressed in terms of the effective grating strength experienced by the diffracted order, $\eta_d$, as

$$R(\lambda) = \frac{\eta_d^2}{\eta_d^2 + 4(1 - \eta_d)\sin^2 \phi(\lambda)/2} \qquad (8)$$

where $\varphi(\lambda)$ is the round-trip phase experienced by the diffracted order in the waveguide region and includes the phase shifts associated with the optical path of the cavity, the two boundary reflections at the two core interfaces and the coupling due to diffraction. The spectral behavior at wavelengths $\lambda$ near the resonance wavelength $\lambda_0$ (and at angles near $\vartheta_0$) is therefore generally Lorentzian.

The effective grating strength, $\eta_d$, represents the coupling efficiency of the grating into a diffraction order and depends on the wavelength, diffraction order, incidence diffraction angle as well on grating parameters such as grating thickness, $t_G$, refraction index contrast, $\Delta n_G/n_G$ and grating period $\Lambda$. In case diffraction occurs only in first order, the coupling efficiency corresponds to the first-order diffraction efficiency and it can be expressed by the ratio of the optical power of the first-order propagating mode to the incident optical power. Essentially, the coupling efficiency tells how effective a grating (coupler) is at redirecting light into a single direction in space. Hereafter, the effective grating strength will be referred to as the coupling efficiency.

The change in $\varphi(\lambda)$ that produces an intensity of ½ gives a FWHM dephasing bandwidth of

$$\Delta\varphi_{FWHM} = 4\sin^{-1}\left[\frac{\eta_d}{2\sqrt{1-\eta_d}}\right],\qquad (9)$$

The dephasing bandwidth can be expressed also as a change in the tangential component as

$$\Delta\lambda_{FWHM} = 4\sin^{-1}\left[\frac{\eta_d}{2\sqrt{1-\eta_d}}\right]\cdot\frac{\Lambda}{k_0\left|\frac{d\varphi}{d\beta}\right|}\qquad (10)$$

where $k_0$ is the wave number in free space at the peak wavelength $\lambda_0$ and $d\varphi/d\beta$ is defined as the modal dephasing rate and represents the rate of change of the phase with respect to the tangential component. The modal dephasing rate is defined as

$$\left|\frac{d\varphi}{d\beta}\right| = \frac{2\beta}{u}\left[t_c + \frac{1}{w_2} + \frac{1}{w_5}\right].\qquad (11)$$

Generally, a relatively high refractive index contrast between the core and the cladding layers leads to a relatively large value of modal dephasing rate and thus to a relatively small value of bandwidth at FWHM [see Eq. (10)].

Equation (10) indicates that the bandwidth decreases with decreasing $\eta_d$ and increasing modal dephasing rate. Therefore, structures having a grating with a relatively small value of $\eta_d$ may exhibit a relatively narrow bandwidth of the spectral response. Gratings characterized by a small value of coupling efficiency, $\eta_d$, into the diffracted mode(s) are also referred to as "weak" gratings, indicating that they have a relatively low grating strength as experienced by the propagating diffracted mode(s).

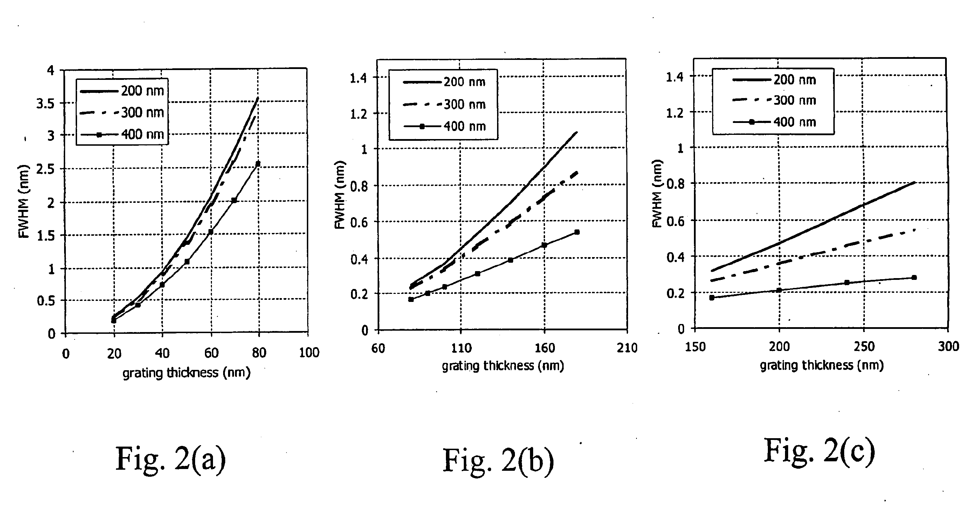

Figures 2(a) to 2(c) show the calculated bandwidth at FWHM of a resonant structure of the type illustrated in Fig.1 as a function of the grating thickness $t_G$ for three different values of core thickness, namely $t_c$=200 nm (thick solid line), 300 (dot-dashed line) and 400 nm (thin solid line with squares). In the calculations the following parameters were assumed: the refractive index of core layer 4, $n_c$=1.96, while the refractive index of both the cladding layer 5 and regions 6 (the low-index regions) of grating 3, $n_L$=$n_3$=1.445. The refractive index of the high-index regions 7 of the grating takes three different values in the graphs of Figs. 2(a) to 2(c). Figure 2(a) refers to a grating index contrast $\Delta n_G/n_G$=0.26, in Fig. 2(b) $\Delta n_G,/n_G$=0.07 and in Fig. 2(c) $\Delta n_G/n_G$=0.04. Calculations of FWHM were derived from Eq. (10). The reference wavelength in the calculations is 1.55 $\mu$m.

As general consideration, the FWHM is observed to increase with increasing grating thickness, $t_G$. However, increase is much more pronounced in case of relatively high index contrast ($\Delta n_G/n_G$=0.26) than in case of relatively small index contrast ($\Delta n_G/n_G$=0.07 and 0.04). In case of $\Delta n_G/n_G$=0.26, a steep increase with $t_G$ is observed, for example increasing the grating thickness from 50 nm to 80 nm leads to an increase of more than a factor of two in the bandwidth at FWHM [Fig. 2(a)]. Although not shown in Fig. 2(a), for $\Delta n_G/n_G$=0.26 a value of grating thickness of about 200 nm results in a FWHM of 20 nm. On the contrary, for $\Delta n_G/n_G$=0.04 grating thickness of 200 nm or larger may still ensure values of FWHM nor larger than 0.5 nm.

From the results shown in Figs. 2(a) to 2(c) we infer that in order to have a relatively low bandwidth at FWHM, i.e., not larger than about 0.6 nm, as required for instance in tunable lasers for DWDM applications with 50 GHz channel spacing, the grating should be selected to have either a very small thickness, i.e., $t_G$ not larger than 30 nm if the grating index contrast is relatively high, or a relatively low index contrast, i.e., not larger than about 0.07 in the examples shown.

The first option of selecting a grating in the resonant structure of Fig. 1 with $t_G$ of a few tens of nm (e.g., 30 nm), which would allow relatively high index contrast $\Delta n_G/n_G$ (e.g., 0.26), would make grating manufacturing particularly cumbersome, especially considering that most technologies, such as chemical vapor deposition or etching, have fabrication tolerances of few nanometers. On the other hand, selecting a low index contrast of not more than 0.05, preferably comprised between 0.03 and 0.04, allows manufacturing of gratings with thickness of at least 150-200 nm.

Figures 2(a) to 2(c) indicate that an increase of the core thickness $t_c$ induces a decrease of FWHM for a given value of grating thickness and of grating index contrast. More generally, a relatively large thickness of the core layer and/or a high refractive index of the core compared to those of the cladding layers produce a relatively low bandwidth at FWHM. However, in case of high index contrast [Fig. 2(a)], for a core thickness of 400 nm a bandwidth at FWHM not larger than 0.5 nm is obtained only for a grating thickness of less than 40 nm.

More generally, spectral response with low bandwidth at FWHM can be realized in a structure having a "weak" grating, i.e., a grating with a relatively small value of coupling efficiency, $\eta_d$. A weak grating can be obtained for instance by either by selecting thin grating structures (small $t_G$) or grating structures with low index contrast (small $\Delta n_G/n_G$). It is to be understood that fulfillment of both conditions leads as well to small values of grating strengths.

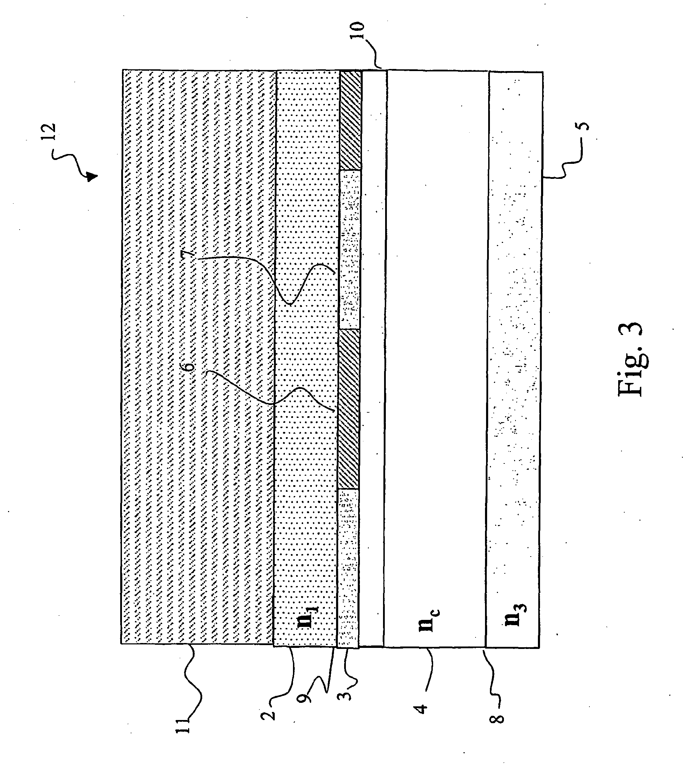

A small coupling efficiency of the grating can be obtained by inserting a layer, referred to as a gap layer, between the core layer and the grating layer. The presence of a gap layer reduces the superimposition between modal field and periodic region, thus weakening the diffractive effect of the field. Figure 3 schematically illustrates a resonant structure 12 including a gap layer 10 placed between the core layer and the grating layer. The structure comprises also a glass sheet 11 that acts as cover plate for the tunable layer 2. A cover plate is preferred in case the light-transmissive material is a LC material. The same reference numerals are given to elements of the resonant structure corresponding to those shown in Fig. 1 and their detailed explanation is omitted.

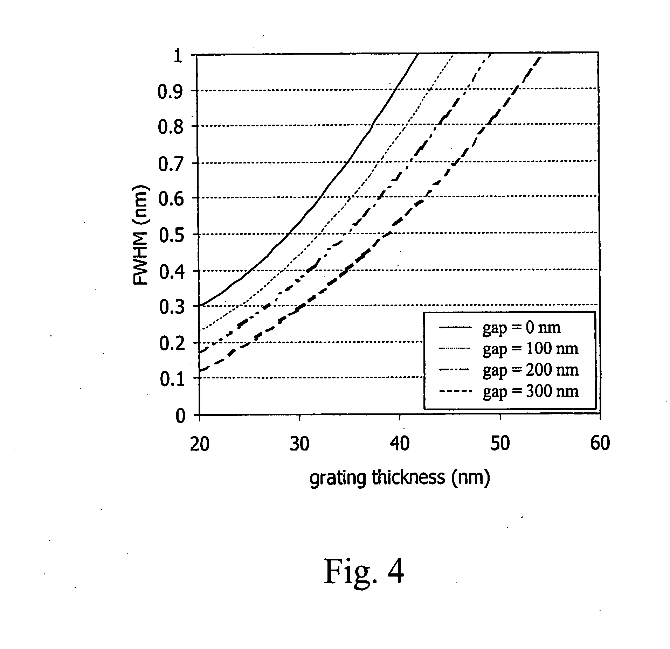

Figure 4 reports the bandwidth at FWHM of the resonant structure of Fig. 3 as a function of the grating thickness, $t_G$, for different values of thickness of the gap layer, $t_{gap}$, ranging from 0 nm (i.e., no gap layer, thus the structure is equivalent to that illustrated in Fig. 1) to 300 nm. Calculations of FWHM were derived from Eq. (10), where the following structural parameters were assumed: $\Delta n_G/n_G$=0.26, $t_c$=200 nm, A=950 nm, $n_c$=1.96 ($Si_3N_4$), and $n_3$=1.445 (undoped $SiO_2$) In the present example, the gap layer is made of $SiO_2$. The curve for $t_{gap}$=0 nm corresponds to the curve reported in Fig. 2(a) for $t_c$=200 nm. Results illustrate that values of FWHM decrease with increasing thickness of the gap layer. For instance, for a grating thickness $t_G$=30 nm, the value of FWHM for $t_{gap}$=300 nm is about a factor 1.7 smaller than the value for $t_{gap}$=0.

Besides having a spectral response having a suitable bandwidth, e.g., compatible with DWDM applications, the resonant grating filter should exhibit a wide-range tunability, i.e., a large tuning range. Preferably, the tuning range is not smaller than 10 nm, more preferably not less than 30-40 nm, e.g., for applications requiring a tuning range that covers the erbium C-band.

Tunability implies a shift of resonance wavelength in the resonant grating filter. In order to shift the resonance wavelength, the solution of the eigenvalue problem (Eq. 5) should shift. One way to change the resonance condition, i.e., to shift the resonance wavelength, is by varying the refractive index of one of the layers of the resonant structure which influence the effective refraction index, $n_{eff}$, of the propagation mode in the core.

To a first approximation, the resonance wavelength, $\lambda_0$, can be expressed by

$$\lambda_0 = n_{eff} \cdot \Lambda \tag{12}$$

where $\Lambda$ is the grating period. The tuning range $\Delta\lambda_0$ of the resonance wavelength can then be given by

$$\Delta\lambda_0 = \Delta n_{eff} \cdot \Lambda, \tag{13}$$

indicating the direct proportionality between $\Delta\lambda_0$ and the variation of the effective refractive index, $\Delta n_{eff}$, of the propagation mode.

The core layer and the periodic structure (grating) are not good candidates for tunable layers, i.e., layers in which the refractive index is varied to tune the resonance wavelength, because change in their refractive index would strongly affect the bandwidth at FWHM and thus would hinder the uniformity of spectral response of the structure at different resonance wavelengths.

It is therefore preferable to achieve tuning by varying the refractive index of a cladding layer of the resonant structure. In the resonant structure of Fig.1, the tunable layer is cladding layer 2, which is preferably made of a liquid crystal (LC) material having a wide range of selectable indices of refractions. The refractive index $n_1$ of the LC layer varies in response to an electric field applied to it, making the resonant grating structure electrically tunable.

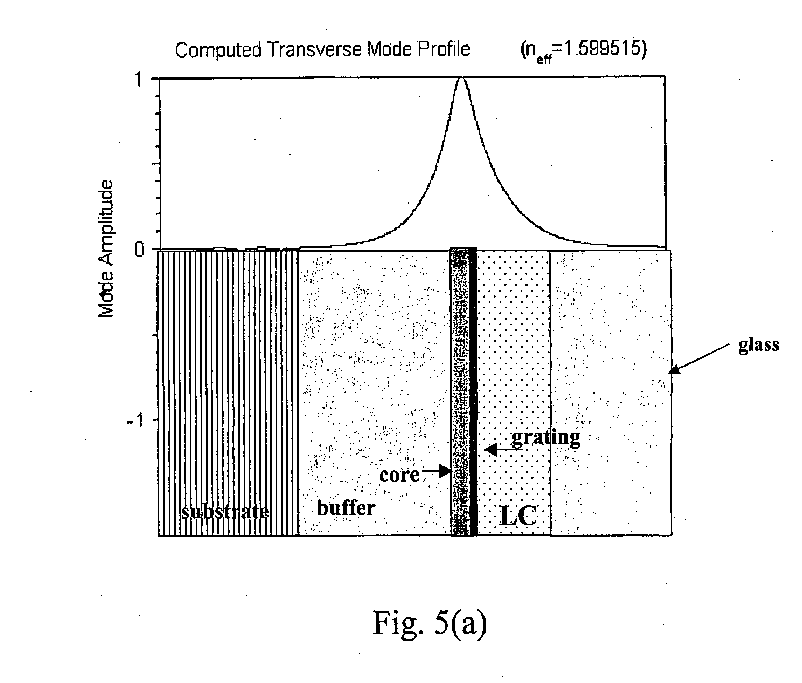

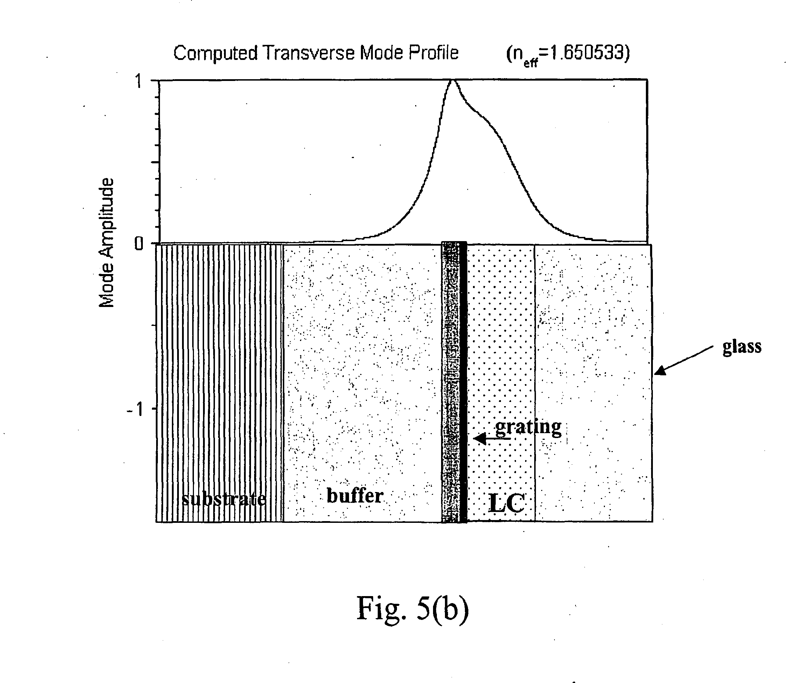

Applicants have observed that in order to achieve efficient tunability, the optical mode profile of the propagation mode should spatially extend so as to significantly overlap the tunable layer. In this way, a variation in the refractive index $n_1$ of the tunable layer will lead to a significant variation of the effective refractive index $n_{eff}$ of the propagation mode in the waveguide. Figures 5(a) and 5(b) report two examples of optical mode profile with respect to the different layers of a resonant structure of the type shown in Fig. 1. In Figs. 5(a) and 5(b), the resonant structure also comprises a glass plate for covering the LC material. The modal field was computed by means of a commercial software based on a finite difference time domain technique. The amplitude of the fundamental optical mode is shown in the top part of Figs. 5(a) and 5(b). Structural parameters assumed in the simulations were the following: $\Delta n_G/n_G=0.26$, $t_c=200$ nm, A=950 nm, $n_c=1.96$ ($Si_3N_4$), and $n_3=1.445$ (undoped $SiO_2$) and $t_G=30$ nm. The refractive index $n_1$ of the tunable cladding layer (LC material) varies from 1.5 to 1.7. In Fig. 5(a) $n_1=1.5$, whereas in Fig. 5(b) $n_1=1.7$. The fundamental propagation mode of the resonant structure is quasi-Gaussian and exhibits a "tail" extending into the tunable layer, the tail representing the spatial overlap of the mode into the layer. The extent of overlap in the LC layer and the curve shape of the fundamental mode is affected by the variation of the refractive index $n_1$, as it can been seen from the comparison between Fig. 5(a) and Fig. 5(b). The calculated effective refractive index, $n_{eff}$, for $n_1=1.5$ resulted to be 1.5995, whereas $n_{eff}$ was 1.6505 for $n_1=1.7$. From Eq. (13), it is possible to derive the tuning range, $\Delta\lambda_0$, which is equal to 48.5 nm.

Calculations of the effective refractive index of the fundamental propagation mode were carried out also for a structure equivalent to that of the example of Figs. 5(a) and 5(b), with the only difference that the grating thickness, $t_G$, was taken to be 200 nm, instead of 30 nm as in the above examples. The variation of the effective refractive index was calculated to be 0.02291, which corresponded to $\Delta\lambda_0$ of 22.9 nm, less than a factor of two smaller than in the example of Figs. 5(a) and 5(b). This indicates that, within the structure of the type as shown in Fig. 1, a grating having a small thickness is preferred in order to improve tunability as separation between the core layer and the tunable layer increases, thereby affecting the overlap of the fundamental mode into the tunable layer. As observed previously, a grating with such as a small thickness (e.g., 30 nm) is often technologically critical.

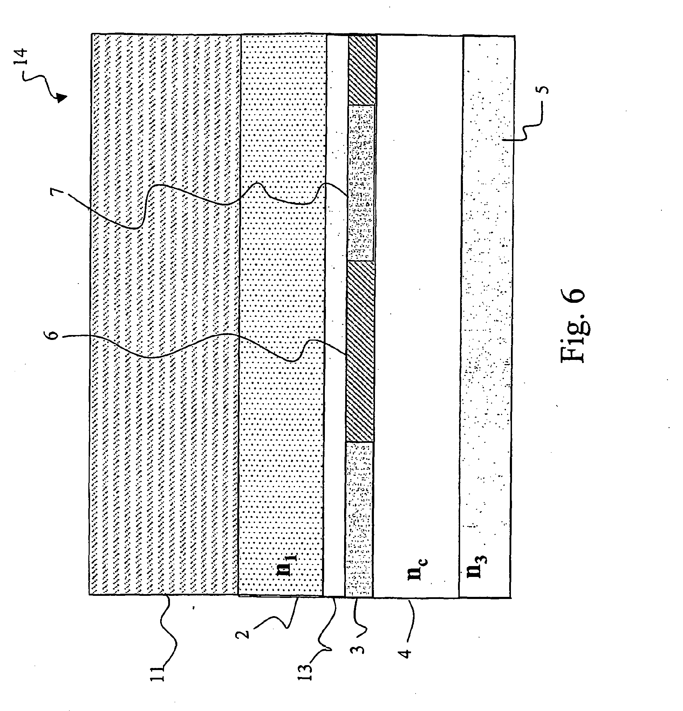

Applicants have observed that inserting a layer, referred herein to as an intermediate layer, between the grating layer and the tunable layer could affect tunability. Figure 6 schematically illustrates a resonant grating structure 14 including an intermediate layer 13 placed between the grating layer 3 and the tunable layer 2. The intermediate layer should have refractive index less than that of the core layer. The same reference numerals are given to elements of the resonant grating filter corresponding to those shown in Fig. 1 and their detailed explanation is omitted.

An intermediate layer between the grating and the tunable layer may be envisaged in the design of certain resonant filters. For instance, the intermediate layer can be a light transparent conducting layer, e.g. made by indium tin oxide (ITO), to be used as an electrode for the control of the tunable layer. Alternatively, an intermediate layer may be interposed in order to improve the adherence of the light transmissive material forming the tunable layer to the underlying layers. In case the light-transmissive material is a LC material, an intermediate layer, made for instance of polymide, can be placed in contact with the LC as aligning layer.

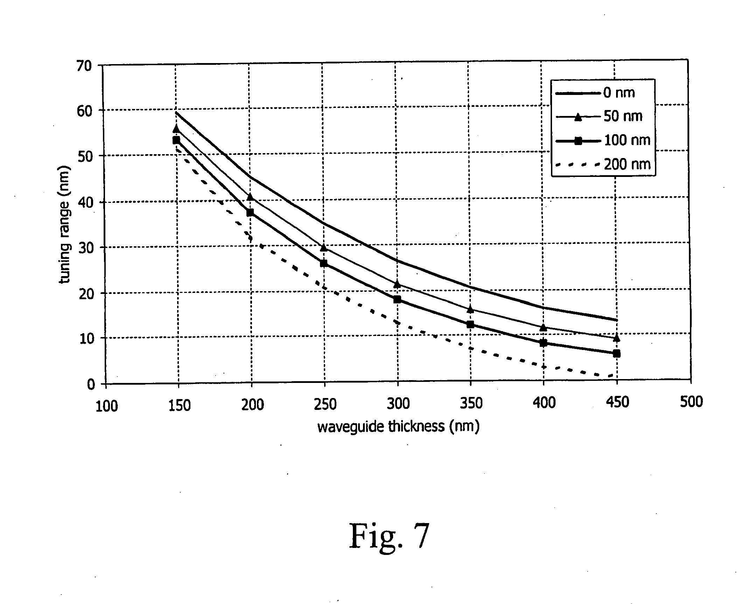

In Fig. 7, the tuning range of a structure of the type illustrated in Fig. 6 is shown as a function of the waveguide (core) thickness, $t_c$, for different values of the thickness of the intermediate layer, the values ranging from 0 nm (i.e. no intermediate layer) to 200 nm. The tuning range is calculated using Finite Difference Time Domain software and by means of Eq. (13). Structural parameters considered in the calculation of curves are: $\Delta n_G/n_G=026$, A=950 nm, $n_c=1.96$ and $n_3=1.445$ and $t_G=30$ nm, and $\Delta n_1=0.2$, where $n_1$ ranges from 1.5 to 1.7. The intermediate layer is taken in this example to be made of $SiO_2$. Results show that the tuning range decreases with increasing core thickness. In addition, for a given core thickness, tuning range decreases with increasing thickness of the intermediate layer.

Results reported in Fig. 7 clearly indicate that tunability is significantly affected by the core thickness, $t_c$, and/or by the presence of an intermediate layer situated between the grating layer and the tunable layer. In both cases, this is due to the fact that the center of the propagation mode in the waveguide becomes more distant from the tunable layer (normally, the fundamental mode is centered at about the core center) and thus cannot significantly overlap into the tunable layer and thus efficiently change the effective refractive index.

By comparing the results illustrated in Figs. 2(a) to 2(c) with the results reported in Fig. 7, applicants have noted that a relatively thick core layer is desirable for relatively narrow bandwidth of the spectral response, whereas a relatively thin core layer is advantageous for wide-range tunability. As an example, by selecting a grating having $\Delta n_G/n_G=0.04$ and $t_G=200$ nm, the core thickness $t_c$ required in order to have a bandwidth at FWHM of 0.4 nm is of about 220 nm. However, such a core thickness implies a tuning range of 25 nm (structural parameters are assumed to be equal to those of the calculations illustrated in the above mentioned figures). This tuning range would be for instance not suitable for applications in DWDM systems operating in the C-band wavelength region, for which a tuning range of at least 30 nm and preferably of not less than 40 nm is required.

Applicants have found that by placing the diffraction grating on the opposite side of the tunable layer with respect to the planar waveguide it is possible to tailor the grating structural parameters to the desired bandwidth of the filter response without significantly affecting the tunability of the filter. In other words, a resonant structure including a waveguide placed between the grating and the tunable layer allows flexibility in the selection of a suitable grating structure having a relatively small coupling efficiency, as required for bandwidth resolution, while attaining the desired tuning range.

The core layer can be placed close to the tunable layer, either in direct contact with the tunable layer or with one or more interposed relatively thin intermediate layer between the core and the tunable layer. The intermediate layer (s) should have a thickness such that it does not affect significantly the tunability, the maximum allowed thickness depending on the refractive index and on the thickness of the waveguide and on the refractive index of the intermediate layer. For example, for a 200nm-thick core layer of $Si_3N_4$ and an intermediate layer of ITO (n=1.9), the thickness of the ITO should be not larger than 40 nm. Proximity of the core layer to the tunable layer implies that the propagation mode can partially extend into the tunable layer so that the effective refractive index is efficiently affected by variations of the refractive index of the tunable layer.

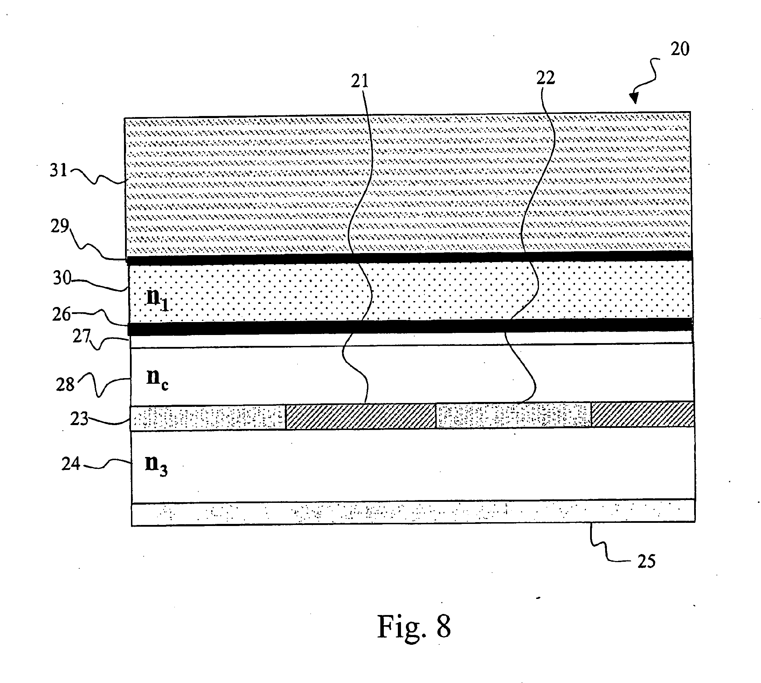

Figure 8 schematically depicts a layer structure of a resonant grating filter according to a preferred embodiment of the present invention. Resonant structure 20 comprises a core layer 28 formed over a diffraction grating layer 23 including low-index regions 21 and high-index regions 22, the refractive index contrast between the low- and the high-index regions being $\Delta n_G / n_G$. The grating layer 23 is formed over a buffer layer 24, which is optionally formed on a substrate 25. A cladding layer 30 is formed above the core layer 28, the cladding layer being formed of a tunable light-transmissive material, preferably of a LC material having a relatively wide range of selectable refractive indices.

The refractive index of the core layer 28, $n_c$, is larger than the surrounding layers to guarantee confinement of the optical modes in the waveguide. The refractive index $n_c$ is larger than the average refractive index of the grating, $n_G$.

The refractive index of the tunable material can be varied by changing an external parameter, e.g., the electric field provided by the application of a voltage (V) or the temperature (T). A suitable tunable material for the cladding layer is selected so that its refractive index $n_1(V)$ [or $n_1(T)$] remains smaller than that of the core in the entire voltage (temperature) range of interest for the functioning and tunability of the device.

In case the tunable layer comprises an electro-optical material, the resonant strcture preferably includes transparent electrically conducting layers 26 and 29 are located on opposite surfaces of the LC layer. Alternatively, the two layers for contacting electrically the structure can be layer 29 and substrate 25, assuming of course that the substrate is conducting or semi-conducting (for instance made of silicon). Preferably, a glass plate 31 is placed as cover plate for the LC layer.

With reference to Fig. 8, in a preferred embodiment, the low-index regions 21 of the grating are made of the same material as that of the buffer layer 24.

Optionally, an intermediate layer 27 is formed over the core layer. An intermediate layer may improve adherence of the conducting layer 26, and/or its thickness uniformity, especially when made by sputtering or deposition.

Optionally, there may be an anti-reflection coating over the cladding layer 30 and/or an anti-reflection coating between the substrate 25 and the buffer layer 24 (not shown).

Although the diffraction grating is shown to have a rectangular configuration, other configurations can be envisaged for the periodic structure as long as the grating allows the coupling of optical radiation in the waveguide region. The diffraction grating should produce a periodic perturbation, either one-dimensional, as in the resonant structure of Fig. 8, or two-dimensional. Periodicity of the grating can be single or multiple and can be dependent on or independent of the polarization of the incident light.

In case the tunable cladding 20 is made of an electro-optically tunable material, such as a LC material, wavelength selectivity is achieved by an electric signal. The resonant wavelength may be shifted by varying the voltage or current supplied to the electro-optically controlled material. When the electro-optical material is a LC material, the electrical signal provided for the functioning of the filter is an alternating voltage to prevent deterioration of the LC due to dc stress. Depending on the amplitude of the voltage applied to the conductors (in Fig. 8, conducting layers 26 and 29), the tunable filter reflects radiation only at a given wavelength $\lambda_0$. Radiation at all other wavelengths passes through the resonant filter. Obviously, the minimum of transmittance occurs at $\lambda_0$.

Although theoretically reflectivity at $\lambda_0$ is 100%, actual reflectivity of resonant grating filters is generally of 70%-95% because e.g. of losses originating from the substrate or the buffer layer, allowing a (small) portion of incident light to be transmitted.

The thickness of the LC material is preferably not larger than about 5 $\mu$m, more preferably of not more than 2 $\mu$m, being in a preferred embodiment of about 1 $\mu$m.

Although preferred, the tunable cladding does not need to be made of an electro-optical material. For example, the use of a thermo-optical material, such as polymer, can also be envisaged. The requirement for the material forming the tunable cladding is that it should have a refractive index that varies in a relatively wide range upon a variation of an external parameter, temperature (T) or electric field. For thermo-optical materials, in order to obtain a tunability of several nanometers for a reasonable temperature variation, the thermo-optical material should have a thermo-optic coefficient, dn/dT, of not less than $10^{-4}/°C$. A large class of LC materials exhibits an electro-optic coefficient sufficiently large to achieve a tuning range of a few tens of nm for a reasonable variation of electric field, typically not larger than 1-2 V/$\mu$m. The choice of a proper material, either electro-optical or thermo-optical, is of course dependent on the application, i.e., on the required tuning range.

It is to be understood that in case of a tunable layer made of a thermo-optical material, only a conductor is necessary for thermal tuning. With reference to Fig. 8, only the conducting layer 29 (not conducting layer 26) would be necessary for tuning the filter. In addition, cover plate 31 is not necessary in case layer 30 is a polymeric layer.

In a preferred embodiment, grating period $\Lambda$ is selected so that only the first diffraction order is generated in the waveguide, i.e., the following condition should be satisfied: $\Lambda > \lambda_{max}/n_C$. where $\lambda_{max}$ is the largest wavelength of the range of interest, e.g., in case the range is the C-band, $\lambda_{max} \sim 1570$ nm. Preferably, the grating period should be selected so that the second order diffraction does not occur and there is coupling in the waveguide between the fundamental propagation mode and the first-order diffraction mode. This last condition can be expressed by the relation

$$\Lambda < \min\left\{\frac{2\lambda_{min}}{n_C}, \frac{\lambda_{min}}{\max[n_1, n_3]}\right\}. \tag{14}$$

where $\lambda_{min}$ is the smallest wavelength of the range of interest, e.g., in case the range is the C-band, $\lambda_{min} \sim 1530$ nm.

As an example, for $t_c=200$ nm, $\Lambda$ may vary from about 800 to 1050 nm.

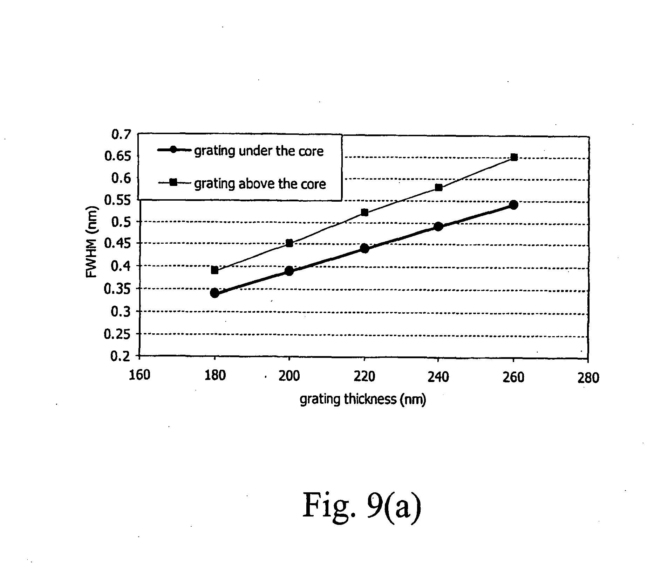

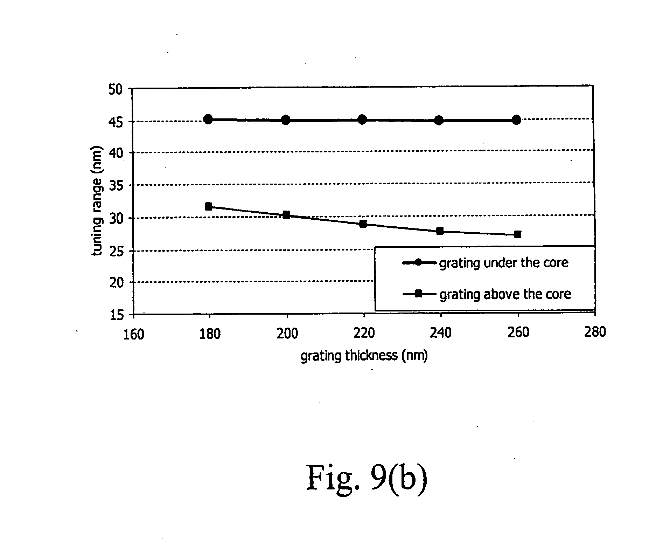

In Figs. 9(a) and 9(b), a comparison is illustrated between the performances of a structure of the type of Fig. 3 and those of a structure of the type shown in Fig. 8, both structures having no intermediate layer between the tunable layer and the core layer. With reference to Fig. 3, no layer 10 is present and with reference to Fig. 8, no layers 27 or 26 are present. In Fig. 9(a), the bandwidth at FWHM is shown as a function of grating thickness for a structure of the type of Fig. 3 (thin solid line with filled squares labeled "grating above the core") and for a structure of the type illustrated in Fig. 8 (thick solid line with filled circles labeled "grating under the core"). In Fig. 9(b), the tuning range is reported as a function of the grating thickness. In the calculations, both structures have the following parameters: $n_c=1.96$, $n_3=1.445$, as that of the low-index grating regions, $t_c=200$ nm, $A=948$ nm, $\Delta n_G/n_G=0.04$, and $n_1=1.5-1.7$. The difference between the two structures is of course the position of the grating layer. Data shown of Fig. 9(a) for the structure with the grating above the core layer correspond to the data reported in Fig. 2(c) for $t_c=200$ nm. Results of Fig. 9(a) clearly indicate that, at any considered grating thickness, the bandwidth at FWHM for the structure with the grating placed under the core layer is narrower than that of the structure having the grating between the core layer and the tunable layer. In addition, Fig. 9(b) shows that the tuning range is considerably larger for the structure with the grating placed under the core layer than for a structure with a grating layer above the core.

It is important to note that the tuning range for the structure with the grating under the core remains approximately constant (at about 45 nm) in the considered range of grating thickness. On the contrary, for the structure with the grating above the core a dependence on grating thickness is observed. This implies that, in a resonant structure having a grating under the waveguide, tunability is less affected by fluctuations in grating thickness, due for instance to a finite accuracy related to the manufacturing process. Fabrication tolerances of the grating can thus be relaxed in case of a structure according to the present invention.

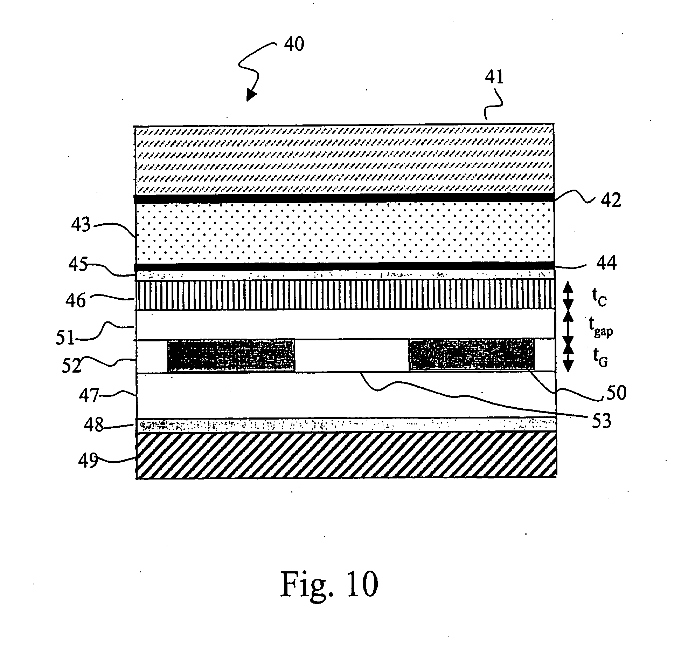

Figure 10 shows a resonant grating filter according to a further embodiment of the present invention. In resonant grating filter 40, a buffer layer 47 is formed on substrate 49. High-index regions 50 are formed in the buffer layer so as to form a grating layer of thickness $t_G$ in which the low-index regions 53 correspond to the regions of the buffer layer laterally adjacent to the high-index regions. Optionally, a gap layer 51 with thickness $t_{gap}$ is formed on the grating layer, the gap layer being preferably made of the same material as the buffer layer. On the gap layer 51 (or on the grating layer) a core layer 46 is formed. An optional intermediate layer 45 can be formed on the core layer. An electro-optically controlled tunable layer 43 is formed above the core layer. An optional anti-reflection coating layer 48 is formed between the substrate 49 and the buffer layer 47. Transparent electrically conducting layers 42 and 44 are located on opposite surfaces of the tunable layer, preferably of LC material. Alternatively, the two layers for contacting electrically the structure can be layer 42 and substrate 49, in case the substrate is conducting or semi-conducting (for instance made of silicon). In case of an insulating substrate, such as glass, an electrically conducting layer can be grown on the substrate (in Fig. 10, in the position corresponding to optional layer 48) so that electric contact can be made between that conducting layer and conducting layer 42 (or 45). A glass cover plate 41 is placed on the tunable layer 43.

A gap layer may be preferably included in the structure in order to reduce the overlap of the fundamental mode on the grating, thereby reducing the coupling efficiency of the grating without changing the characteristics of the grating itself.

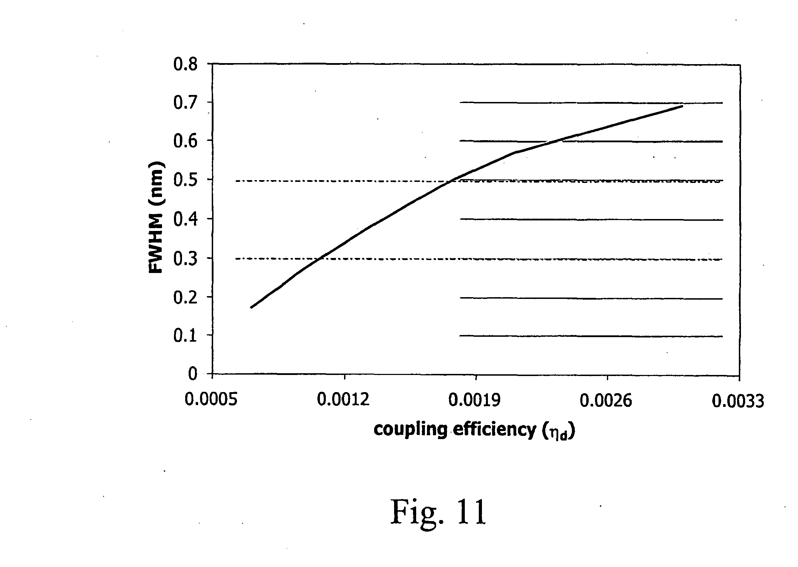

Preferably, the resonant grating filter according to the invention comprises a grating having a relatively small diffraction efficiency. Figure 11 shows the bandwidth at FWHM as a function of the coupling efficiency, $\eta_d$, as calculated using a commercial software based on the solution of the coupled wave equation for a structure of the type shown in Fig. 10. In the range of FWHM considered, the dependence of FWHM on $\eta_d$ is to a first approximation linear. If the desired FWHM is of 0.4 nm, the coupling efficiency should be of 0.0015. A coupling efficiency ranging from about 0.001 to 0.002 correspond to a FWHM from approximately 0.2 to 0.5 nm.

Applicants have noted that, for all resonant structures of the examples so far considered, the curve of bandwidth at FWHM vs. coupling efficiency does not appreciably change. It is to be understood that in the calculations grating thickness should be changed in order to have the same coupling efficiency for different values of $\Delta n_G/n_G$. For instance, a coupling efficiency of 0.0014 can be obtained by a resonant structure with grating above the core having $\Delta n_G/n_G=0.26$ and $t_G=25$ nm; by a structure with grating below the core with $\Delta n_G/n_G=0.04$ and $t_G=200$ nm; or by a structure with grating below the core and gap layer, in which $\Delta n_G/n_G=0.04$, $t_G=50$ nm and $t_{gap}=100$ nm.

Within the context of the present invention, a diffraction grating is considered "weak", i.e., with a relatively small coupling efficiency, if $\eta_d$ is not larger than about 0.0026.

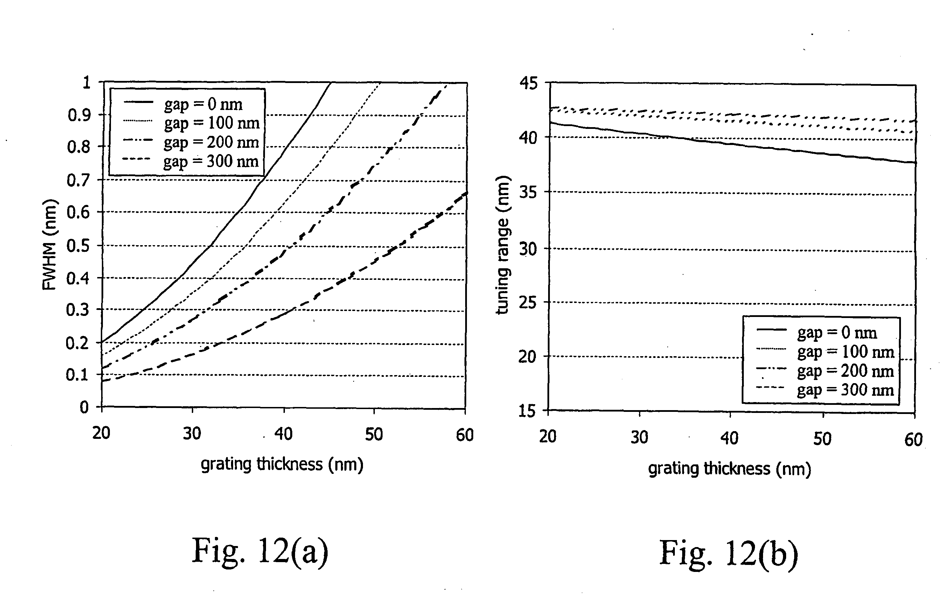

Figures 12(a) and 12(b) report the bandwidth at FWHM and the tuning range, respectively, as a function of the grating thickness for a structure of the type shown in Fig. 10 for different values of thickness of the gap layer, $t_{gap}$, ranging from 0 hm to 300 nm. Solid line referring to $t_{gap}=0$ corresponds to a structure with no gap layer, i.e., the core layer is formed directly on the grating layer. Structural parameters were the following: $n_c=1.96$, $n_3=1.445$, as that of the low-index grating regions, $t_c=200$ nm, A=950 nm, $\Delta n_G/n_G=0.26$, and $n_1=1.5$-1.7. Curves exhibit only a relatively weak dependence of the tuning range on the thickness of the gap layer, at least in the considered range 0-300 nm. It is to be noted that an increase in gap thickness can be considered equivalent in terms of optical performance to an increase in grating thickness.

It is to be noted that in the resonant structure of the present invention there is no need to fabricate a grating with a relatively small thickness, i.e., smaller than 150-220 nm, to obtain a weak diffraction grating. On the other hand, if a relatively thin (e.g., 50 nm) grating is desired, the formation of the grating layer can be well controlled and reproduced because it is possible to define the grating thickness by means of the deposition process, e.g., by plasma-enhanced chemical vapor deposition. To reproduce the low- (or high-) index regions of the grating, an etching step is generally needed. Current etching techniques generally exhibit an absolute accuracy of at least 4-5 nm. This can be problematic if the grating layer is arranged above the core layer, as the core layer itself may be affected by etching.

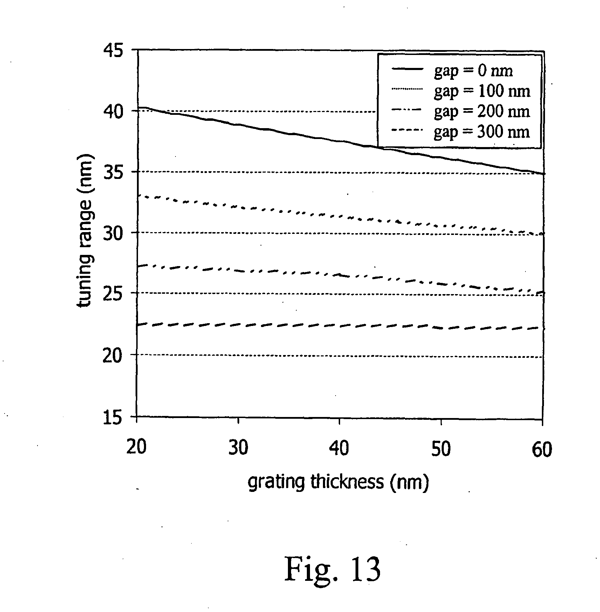

For comparison, the tuning range as a function of the grating thickness is shown in Fig. 13 for a structure of the type of that depicted in Fig. 3, i.e., with the grating layer placed above the core layer and a gap layer between the core layer and the grating. Curves refer to different values of thickness of the gap layer, $t_{gap}$, ranging from 0 nm to 300 nm. Structural parameters are the same as those of the calculations reported in Fig. 4. For a given grating thickness, a significant decrease of the tuning range is observed with increasing the thickness of the gap layer.

Example 1

Referring to Fig. 8, the buffer layer and the low-index grating regions are made of (undoped) $SiO_2$ having refractive index of 1.445; the high-index grating regions are made of $SiO_xN_y$ having refractive index of 1.54; the core layer is made of $Si_3N_4$ with refractive index of 1.96. The grating thickness is of 220 nm, while the core thickness is of 200 nm. The tuning layer is made of nematic LC that has a refractive index ranging from 1.5 to 1.7. The grating period is of 948.5 nm in order to have a resonance wavelength at 1526 nm (lower limit of the C-band) for a refractive index of the LC material of 1.5.

The structure can be fabricated by utilizing standard technologies for the manufacturing of semiconductor devices. As an example, the layer of $SiO_2$ is deposited by PECVD on a Si substrate in order to form the buffer layer. The surface of the buffer layer is subsequently etched, e.g., by dry etching, to form trench regions that correspond to high-index grating regions 22 to be formed. Trenches are subsequently filled with $SiO_xN_y$. Alternatively a layer of $SiO_xN_y$ can be deposited on the substrate as buffer layer and then trenches corresponding to the low-index regions can be formed on its surface, which are subsequently filled with $SiO_2$.

The resulting surface (i.e., the grating upper surface) is then planarised. In a successive step, a layer of $Si_3N_4$ is deposited by PECVD in order to form the core layer. A thin layer, not thicker than 40 nm, of $SiO_2$ can be optionally deposited on the core layer by PECVD. In a further step, a 30 nm-thick layer of ITO is deposited on the core layer or on the thin $SiO_2$ layer. The LC cell is finally assembled on the top of the structure and terminated with an ITO layer and a glass plate.

Tuning range of the resonant structure is of about 40 nm.

Example 2

Referring to a structure of the type shown in Fig 10, the buffer layer and the gap layer are made of (undoped) $SiO_2$ having refractive index of 1.445; the high-index grating regions are made of $Si_3N_4$ having refractive index of 1.96; the core layer is made of $Si_3N_4$ with refractive index of 1.96. The grating thickness is of 50 nm, the core thickness is of 200 nm, and the thickness of the gap layer is of 300 nm. The tuning layer is made of nematic LC which has a refractive index ranging from 1.5 to 1.7. The grating period is of 950 nm in order to have a resonance wavelength at 1526 nm (lower limit of the C-band) for a refractive index of the LC material of 1.5. A glass plate of about 1 mm of thickness covers the LC cell. Transparent conducting layers made of ITO and being 20 nm thick are placed on opposite surfaces of the LC cell. Above the ITO layer placed on the core layer, a 20 nm-thick polymide layer is formed in order to align the LC material.

Tuning range of this resonant structure is of 40 nm.

The structure can be fabricated by utilizing standard technologies for the manufacturing of semiconductor devices. As an example, a layer of $SiO_2$ is deposited by PECVD on a Si substrate in order to form the buffer layer. Subsequently, a layer of $Si_3N_4$ is deposited on the buffer layer. The $Si_3N_4$ layer is subsequently etched, e.g., by dry etching, to form trench regions that correspond to the low-index grating regions to be formed. A layer of $SiO_2$ is deposited in order to fill the trenches and to form the gap layer of $SiO_2$ on the grating.

This process has the advantage that a high accuracy in the etching step of the trenches is not necessary, and a slight over-etch of the trenches is possible. In this case, the accuracy of the grating thickness is defined by the deposition process of the high-index regions of $Si_3N_4$.

In a preferred embodiment, the resonant grating filter according to the invention is used as a tuning element in an external-cavity tunable laser. The external-cavity tunable laser is particularly suitable as tunable light source in telecom applications, especially for WDM and DWDM systems, to generate the center wavelengths for any channel on the International Telecommunications Union (ITU) grid.

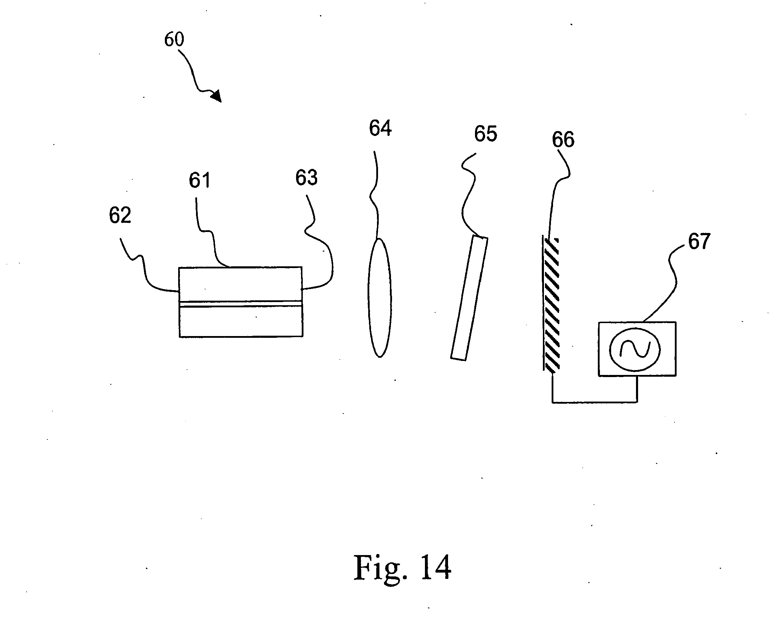

Figure 14 schematically depicts an external-cavity tunable laser 60 comprising a tunable resonant reflecting filter according to the invention. Gain medium 61, preferably a semiconductor laser diode, comprises a front facet 62 and a back facet 63. Front facet 62 is partially reflecting and serves as one of the end mirrors of the external cavity. Back facet 63 has a low reflectivity. It is typically coated with an anti-reflection coating (not shown). A collimating lens 64 converges the optical beam emitted by the gain medium onto a Fabry-Perot etalon (FP) 65, which has the modes locked to the ITU channel grid. The FP etalon functions as a channel allocation grid element, which is structured and configured to define a plurality of equally spaced transmission peaks. After the FP etalon 65, the beam impinges on a tunable resonant grating filter 66, which forms the other end mirror of the external cavity and together with the gain medium front facet defines the cavity physical length, $L_0$. Tunable filter 66 serves as an end mirror of the laser cavity and will be also referred to as the tunable mirror. The tunable mirror is tuned to the desired channel frequency by selecting one of the etalon transmission peaks.

In a preferred embodiment, the tunable mirror 66 is tuned electrically by varying the applied voltage supplied by a voltage generator 67. The applied voltage is an alternating current (AC) voltage. The lasing output wavelength of the laser is selected to correspond to the resonance wavelength $\lambda_0$ of the tunable mirror. The tunable mirror 66 is a resonant grating filter according to one of the preferred embodiments of the invention.

The laser system is preferably designed to produce substantially single longitudinal and, preferably, single transversal mode radiation. Longitudinal modes refer to the simultaneous lasing at several discrete frequencies within the laser cavity. Transversal modes correspond to the spatial variation in the beam intensity cross section in the transverse direction of the lasing radiation. Generally, an appropriate choice of the gain medium, e.g., a commercially available semiconductor laser diode including a waveguide, guarantees single spatial, or transversal, mode operation.

In a preferred embodiment, impingement of the beam is substantially perpendicular to the waveguide surfaces of the tunable mirror.

In the laser system of Fig. 14, the tunable mirror serves as the coarse tuning element that discriminates between the peaks of the grid etalon. The FWHM bandwidth of the tunable mirror is not smaller than the FWHM bandwidth of the grid etalon. For longitudinal single-mode operation, the transmission peak of the FP etalon corresponding to a particular channel frequency should select, i.e., transmit, a single cavity mode. Therefore, the FP etalon should have a finesse, which is defined as the free spectral range (FSR) divided by the FWHM, which suppresses the neighboring modes of the cavity between each channel. For single-mode laser emission, a longitudinal cavity mode should be positioned over the maximum of one of the etalon transmission peaks (the one selected by the tunable mirror). In this way, only the specified frequency will pass through the etalon and the other competing neighboring cavity modes will be suppressed.

The laser system according to the present invention is designed especially to provide fast switching over the entire C-band on the ITU 50 GHz or 25 GHz channel grid.

If the laser system is designed for 50-GHz mode spacing, the reflection band of the tunable mirror should be not larger than about 0.6 nm in order to obtain an extinction ratio of at least 5 dB between neighboring channels. Preferably the bandwidth at FWHM of the tunable mirror is not larger than 0.4 nm. Tunability of the laser system over the C-band requires a tunable mirror having tuning range of at least 40 nm.

For applications as tunable mirror in an extemal-cavity laser source for DWDM system with 25 GHz channel spacing, a bandwidth at FWHM comprised between about 0.2 nm and 0.3 nm is preferred.

A bandwidth at FWHM of less than 0.2-0.3 nm is less desirable in laser systems as it makes more difficult the alignment and control of the mirror in the laser. '

Alternatively, the resonant grating filter according to the present invention can be used in a tunable add/drop device for WDM and DWDM systems. For this application, design should be tailored, besides wide-range tuning, to narrow bandwidths, e.g., 0.1-0.2 nm, and low sidebands around the resonance wavelength, with extinction ratio of the lateral modes preferably not larger than -30 dB.

**Claims**

1. An optical resonant grating filter (20;40) reflecting optical radiation at a resonant wavelength, said filter comprising a diffraction grating (23;52) having a periodic structure comprising low-index regions (21;53) and high-index regions (22;50),
a planar waveguide (28;46) optically interacting with said diffraction grating, the diffraction grating and the planar waveguide forming a resonant structure, and
a light transmissive material forming a cladding (30;43) layer for the planar waveguide (28;46),
wherein the planar waveguide is placed between the diffraction grating (23;52) and the cladding layer (30;43),
**characterized in that** the diffraction grating has a coupling efficiency not larger than 0.0026 and **in that** the light transmissive material has a selectively variable refractive index to permit tuning of the filter.

2. The filter (20;40) of claim 1, wherein the light transmissive material is a liquid crystal material whose selectively variable refractive index is controlled by an electric signal.

3. The filter (20;40) of claim 1, wherein the coupling efficiency of the diffraction grating (23;52) ranges from 0.001 to 0.002.

4. The filter (20;40) of claim 1, wherein the planar waveguide (28;46) is a layer having a refractive index $n_c$ larger than the variable refractive index of the tunable cladding layer (30;43) and of the average refractive index of the diffraction grating (23;52)_

5. The filter (20;40) of claim 4. further comprising a buffer layer (24,47) placed opposite to the diffraction grating with respect to the planar waveguide (23;46), said buffer layer having a refractive index $n_3$ being lower than the average refractive index of the diffraction grating (23;52).

6. The filter (20:40) according to claim 1, further comprising an anti-reflection coating formed over said tunable cladding layer (30; 43).

7. The filter (20;40) according to claim 5, wherein said buffer layer (24;47) is disposed over a substrate (25;49), said filter further comprising an anti-reflection coating layer formed between said buffer layer (24;47) and said substrate (25;49).

8. The filter (20;40) according to any of the preceding claims, further comprising a gap layer (51) placed between the planar waveguide (28;46) and the diffraction grating (23;52), said gap layer having a refractive index lower than that of the waveguide and than the average index of the diffraction grating.

9. The filter (20;40) of claims 5 or 8, wherein the planar waveguide (28;46) is made of silicon nitride material, the high-index regions of silicon nitride or silicon oxynitride, and the low-index regions and the buffer layer (24;47) are made of silicon dioxide.

10. The filter (20;40) of claim 8, wherein the gap layer (51) is made of silicon dioxide.

11. The filter (20;40) of any of claims from 2 to 10, further comprising two light transparent electrically conducting layers (26;42;29;44) arranged on opposite sides of the light transmissive material for applying the electric signal across the light transmissive material.

12. An external-cavity tunable laser (60) system configured to emit radiation at a laser emission wavelength, the tunable laser system comprising an external cavity having a plurality of cavity modes, said external cavity including a gain medium (61) to emit an optical beam into the external cavity, and
a tunable optical resonant grating filter (66;20;40) reflecting the optical beam at a resonant wavelength, said filter being a filter as defined in claim 1, wherein
said light transmissive material is a liquid crystal material or a thermo-optical material having a thermo-optic coefficient of not less than $10^{-1}/°C$ so as to form a tunable cladding layer (30;43) for the planar waveguide.

**13.** The laser system (60) of claim 12, wherein said thermo-optical material is a polymer.

**14.** The laser system (60) of claim 12, wherein the tunable optical resonant grating filter (20;40) exhibits a tunability within a tuning range of at least 10 nm.

**15.** The laser system (60) of claim 12, wherein the emitted radiation is on a single longitudinal mode.

**16.** The laser system (60) of claim 12, further comprising a channel-allocation grid element arranged in the external cavity to define a plurality of pass bands substantially aligned with corresponding channels of a selected wavelength grid.

**17.** The laser system (60) of claim 16, wherein the tunable optical resonant grating filter (20;40) is arranged in the external cavity to tunably select one of the pass bands so as to select a channel to which to tune the optical beam.

**18.** The laser system (60) of claims 16 or 17, wherein the selected wavelength grid has a channel spacing of 50 GHz or 25 GHz.

**19.** The laser system (60) of claim 12, wherein the tunable optical resonant grating filter (20;40) being arranged in the external cavity so that the optical beam impinges on the filter substantially perpendicular to a main surface of the planar waveguide.

**Patentansprüche**

**1.** Optischer resonanter Gitterfilter (20, 40), der optische Strahlung bei einer Resonanzwellenlänge reflektiert, wobei der Filter umfasst:

ein Beugungsgitter (23, 52) mit einer periodischen Struktur umfassend Regionen mit niedrigem Index (21, 53) und Regionen mit hohen Index (22, 50),
einen planaren Wellenleiter (28, 46), der mit dem Beugungsgitter in optische Wechselwirkung tritt, wobei das Beugungsgitter und der planare Wellenleiter eine Resonanzstruktur bilden, und
ein lichtdurchlässiges Material, das eine Überzugsschicht (30, 43) für den planaren Wellenleiter (28, 46) bildet,

wobei der planare Wellenleiter zwischen das Beugungsgitter (23, 52) und die Überzugsschicht (30, 43) platziert ist, **dadurch gekennzeichnet, dass** das Beugungsgitter eine Kopplungseffizienz aufweist, die nicht größer ist als 0,0026, und **dadurch**, dass das lichtdurchlässige Material einen selektiv variablen Brechungsindex aufweist, der ein Abstimmen des Filters ermöglicht.

**2.** Filter (20, 40) nach Anspruch 1, wobei das lichtdurchlässige Material ein Flüssigkristallmaterial ist, dessen selektiv variabler Brechungsindex von einem elektrischen Signal gesteuert wird.

**3.** Filter (20, 40) nach Anspruch 1, wobei die Kopplungseffizienz des Beugungsgitters (23, 52) im Bereich von 0,001 bis 0,002 liegt.

**4.** Filter (20, 40) nach Anspruch 1, wobei der planare Wellenleiter (28, 46) eine Schicht mit einem Brechungsindex $n_c$ aufweist, der größer ist als der variable Brechungsindex der abstimmbaren Überzugsschicht (30, 43) und der mittlere Brechungsindex des Beugungsgitters (23, 52).

**5.** Filter (20, 40) nach Anspruch 4, ferner umfassend eine Pufferschicht (24, 47), die dem Beugungsgitter in Bezug auf den planaren Wellenleiter (28, 46) gegenüberliegend angeordnet ist, wobei die Pufferschicht einen Brechungsindex $n_3$ aufweist, der kleiner ist als der mittlere Brechungsindex des Beugungsgitters (23, 52).

**6.** Filter (20, 40) nach Anspruch 1, ferner umfassend eine Antireflexionsbeschichtung, die über der abstimmbaren Überzugsschicht (30, 43) ausgebildet ist.

**7.** Filter (20, 40) nach Anspruch 5, wobei die Pufferschicht (24, 47) über einem Substrat (25, 49) angeordnet ist, wobei der Filter ferner eine Antireflexionsbeschichtung umfasst, die zwischen der Pufferschicht (24, 47) und dem Substrat (25, 49) ausgebildet ist.

**8.** Filter (20, 40) nach einem der vorhergehenden Ansprüche, ferner umfassend eine Spaltschicht (51), die zwischen den planaren Wellenleiter (28, 46) und das Beugungsgitter (23, 52) eingesetzt ist, wobei die Spaltschicht einen Brechungsindex aufweist, der niedriger ist als der des Wellenleiters und als der mittlere Index des Beugungsgitters.

**9.** Filter (20, 40) nach Anspruch 5 oder 8, wobei der planare Wellenleiter (28, 46) aus Siliciumnitridmaterial gebildet ist, die Regionen mit hohem Index aus Siliciumnitrid oder Siliciumoxynitrid und die Regionen mit niedrigem Index und die Pufferschicht (24, 47) aus Siliciumdioxid gebildet sind.

**10.** Filter (20, 40) nach Anspruch 8, wobei die Spaltschicht (51) aus Siliciumdioxid gebildet ist.

**11.** Filter (20, 40) nach einem der Ansprüche 2 bis 10, ferner umfassend zwei lichttransparente elektrisch leitende Schichten (26, 42, 29, 44), die auf gegenüberliegenden Seiten des lichtdurchlässigen Materials angeordnet sind, so dass das elektrische Signal über das lichtdurchlässige Material angelegt wird.

**12.** Abstimmbares Lasersystem (60) mit externem Resonator, das so konfiguriert ist, dass es Strahlung bei einer Laseremissionswellenlänge emittiert, wobei das abstimmbare Lasersystem einen externen Resonator mit einer Mehrzahl von Resonatormoden umfasst, wobei der externe Resonator
ein Verstärkermedium (61) zum Emittieren eines optischen Strahls in den externen Resonator und
einen abstimmbaren optischen resonanten Gitterfilter (66, 20, 40) beinhaltet, der den optischen Strahl bei einer Resonanzwellenlänge reflektiert, wobei der Filter ein Filter wie in Anspruch 1 definiert ist, wobei
das lichtdurchlässige Material ein Flüssigkristallmaterial oder ein thermooptisches Material mit einem thermo-optischen Koeffizienten von nicht weniger als $10^{-4}/°C$ ist, so dass eine abstimmbare Überzugsschicht (30, 43) für den planaren Wellenleiter gebildet wird.

**13.** Lasersystem (60) nach Anspruch 12, wobei das thermo-optische Material ein Polymer ist.

**14.** Lasersystem (60) nach Anspruch 12, wobei der abstimmbare optische resonante Gitterfilter (20, 40) eine Abstimmbarkeit in einem Abstimmbereich von mindestens 10 nm zeigt.

**15.** Lasersystem (60) nach Anspruch 12, wobei die emittierte Strahlung auf einem einzigen Longitudinalmodus (single longitudinal mode) liegt.

**16.** Lasersystem (60) nach Anspruch 12, ferner umfassend ein Kanalzuweisungsgitterelement, das im externen Resonator so angeordnet ist, dass eine Mehrzahl von Passbändern definiert werden, die im Wesentlichen mit zugehörigen Kanälen eines ausgewählten Wellenlängengitters ausgerichtet sind.

**17.** Lasersystem (60) nach Anspruch 16, wobei der abstimmbare optische resonante Gitterfilter (20, 40) im externen Resonator so angeordnet ist, dass abstimmbar eines der Passbänder ausgewählt wird, um einen Kanal auszuwählen, auf den der optische Strahl abgestimmt wird.

**18.** Lasersystem (60) nach Anspruch 16 oder 17, wobei das gewählte Wellenlängengitter einen Kanalabstand von 50 GHz oder 25 GHz aufweist.

**19.** Lasersystem (60) nach Anspruch 12, wobei der abstimmbare optische resonante Gitterfilter (20, 40) im externen Resonator so angeordnet ist, dass der optische Strahl im Wesentlichen senkrecht zu einer Hauptfläche des planaren Wellenleiters auf den Filter auftrifft.

**Revendications**

**1.** Filtre optique (20 ; 40) à réseau résonnant réfléchissant un rayonnement optique au niveau d'une longueur d'onde de résonance, ledit filtre comprenant:

un réseau de diffraction (23 ; 52) ayant une structure périodique comprenant des régions à indice bas (21; 53) et des régions à indice élevé (22; 50),
un guide d'ondes planaire (28; 46) interagissant optiquement avec ledit réseau de diffraction, le réseau de diffraction et le guide d'ondes planaire formant une structure résonnante, et
un matériau transmetteur de lumière formant une couche d'habillage (30 ; 43) pour le guide d'ondes planaire (28 46),

dans lequel le guide d'ondes planaire est placé entre le réseau de diffraction (23; 52) et la couche d'habillage (30; 43),

**caractérisé en ce que** le réseau de diffraction a un rendement de couplage n'excédant pas 0,0026 et **en ce que** le matériau transmetteur de lumière a un indice de réfraction variable de manière sélective pour permettre un accord du filtre.

**2.** Filtre (20 ; 40) selon la revendication 1, dans lequel le matériau transmetteur de lumière est un matériau à cristaux liquides dont un indice de réfraction variable de manière sélective est commandé par un signal électrique.

**3.** Filtre (20; 40) selon la revendication 1, dans lequel le rendement de couplage du réseau de diffraction (23 ; 52) s'échelonne de 0,001 à 0,002.

**4.** Filtre (20 ; 40) selon la revendication 1, dans lequel le guide d'ondes planaire (28 ; 46) est une couche ayant un indice de réfraction $n_c$ plus grand que l'indice de réfraction variable de la couche d'habillage accordable (30 ; 43) et de l'indice de réfraction moyen du réseau de diffraction (23 ; 52).

**5.** Filtre (20 ; 40) selon la revendication 4, comprenant en outre une couche tampon (24, 47) placée en opposition au réseau de diffraction par rapport au guide d'ondes planaire (23 ; 46), ladite couche tampon ayant un indice de réfraction $n_3$ qui est inférieur à l'indice de réfraction moyen du réseau de diffraction (23; 52).

**6.** Filtre (20 ; 40) selon la revendication 1, comprenant en outre un revêtement antireflet formé au-dessus de ladite couche d'habillage accordable (30 ; 43).

**7.** Filtre (20 ; 40) selon la revendication 5, dans lequel ladite couche tampon (24 ; 47) est disposée au-dessus d'un substrat (25 ; 49), ledit filtre comprenant en outre une couche de revêtement antireflet formée entre ladite couche tampon (24; 47) et ledit substrat (25 ; 49).

**8.** Filtre (20 ; 40) selon l'une quelconque des revendications précédentes, comprenant en outre une couche d'espace de séparation (51) placée entre le guide d'ondes planaire (28; 46) et le réseau de diffraction (23; 52), ladite couche d'espace de séparation ayant un indice de réfraction inférieur à celui du guide d'onde et à l'indice moyen du réseau de diffraction.

**9.** Filtre (20 ; 40) selon les revendications 5 ou 8, dans lequel le guide d'ondes planaire (28 ; 46) est fait d'un matériau de nitrure de silicium, les régions à indice élevé étant en nitrure de silicium ou en oxynitrure de silicium, et les régions à indice bas et la couche tampon (24 ; 47) étant en dioxyde de silicium.

**10.** Filtre (20 ; 40) selon la revendication 8, dans lequel la couche d'espace de séparation (51) est faite de dioxyde de silicium.

**11.** Filtre (20 40) selon l'une quelconque des revendications 2 à 10, comprenant en outre deux couches électriquement conductrices et transparentes à la lumière (26 ; 42 ; 29 ; 44) agencées sur des côtés opposés du matériau transmetteur de lumière pour appliquer le signal électrique d'un côté à l'autre du matériau transmetteur de lumière.

**12.** Système laser accordable (60) à cavité externe configuré afin d'émettre un rayonnement au niveau d'une longueur d'onde d'émission laser, le système laser accordable comprenant une cavité externe ayant une pluralité de noyaux de cavité, ladite cavité externe comportant:

un milieu de gain (61) destiné à émettre un faisceau optique dans la cavité externe, et
un filtre optique (66 ; 20 ; 40) à réseau résonnant accordable réfléchissant le faisceau optique au niveau d'une longueur d'onde de résonance, ledit filtre étant un filtre comme défini dans la revendication 1, dans lequel :

ledit matériau transmetteur de lumière est un matériau à cristaux liquides ou un matériau thermooptique ayant un coefficient thermooptique qui n'est pas inférieur à $10^{-4}/°C$ de façon à former une couche d'habillage accordable (30 ; 43) pour le guide d'ondes planaire.

**13.** Système laser (60) selon la revendication 12, dans lequel ledit matériau thermooptique est un polymère.

**14.** Système laser (60) selon la revendication 12, dans lequel le filtre optique (20 ; 40) à réseau résonnant accordable présente une caractéristique d'accord dans les limites d'une plage d'accord d'au moins 10 nm.

**15.** Système laser (60) selon la revendication 12, dans lequel le rayonnement émis est sur un mode longitudinal unique.

**16.** Système laser (60) selon la revendication 12, comprenant en outre un élément de grille d'affectation de canaux agencés dans la cavité externe pour définir une pluralité de bandes passantes sensiblement alignées avec des canaux correspondants d'une grille de longueur d'onde sélectionnée.

**17.** Système laser (60) selon la revendication 16, dans lequel le filtre optique (20 ; 40) à réseau résonnant accordable est agencé dans la cavité externe pour sélectionner de manière accordable une parmi les bandes passantes de façon à sélectionner un canal sur lequel accorder le faisceau optique.

**18.** Système laser (60) selon la revendication 16 ou 17, dans lequel la grille de longueur d'onde sélectionnée a un espacement entre les canaux de 50 GHz ou 25 GHz.

**19.** Système laser (60) selon la revendication 12, dans lequel le filtre optique (20 ; 40) à réseau résonant accordable est agencé dans la cavité externe de sorte que le faisceau optique vienne frapper le filtre de manière sensiblement perpendiculaire à une surface principale du guide d'ondes planaire.

Fig. 1

EP 1 704 428 B1

Fig. 2(c)

Fig. 2(b)

Fig. 2(a)

20

Fig. 3

EP 1 704 428 B1

Fig. 4

Fig. 5(a)

Computed Transverse Mode Profile    ($n_{eff}$=1.650533)

Mode Amplitude

1

0

-1

substrate    buffer    grating    LC    glass

Fig. 5(b)

EP 1 704 428 B1

Fig. 6

Fig. 7

EP 1 704 428 B1

EP 1 704 428 B1

Fig. 8

Fig. 9(a)

Fig. 9(b)

EP 1 704 428 B1

Fig. 10

EP 1 704 428 B1

Fig. 11

Fig. 12(a)

Fig. 12(b)

Fig. 13

EP 1 704 428 B1

60

62  61  63  64  65  66  67

Fig. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6215928 B
- US 6205159 B
- JP 63244004 A
- US 5193130 A
- US 5337183 A

**Non-patent literature cited in the description**

- **WANG S.S. ; R. MAGNUSSON.** Multilayer waveguide-grating filters. *Applied Optics,* 1995, vol. 34, 2414
- **DONALD K.J. et al.** Design considerations for narrow-band dielectric resonant grating reflection filters of finite length. *J. Opt. Soc. Am. A,* 2000, 1241
- **ROSENBLATT D. et al.** Resonant Grating Waveguide Structures. *IEEE Journal of Quantum Electronics,* 1997, vol. 33, 2038
- **G. LEVY-YURISTA ; A.A. FRIESEM.** Very narrow spectral filters with multilayered grating-waveguide structures. *Applied Physics Letters,* 2000, vol. 77, 1596
- **DUDOVICH N. et al.** Active Semiconductor-Based Grating Waveguide Structures. *IEEE Journal of Quantum Electronics,* 2001, vol. 37, 1030